# EUROPEAN PATENT SPECIFICATION

(11) **EP 3 119 170 B1**
(45) Date of publication and mention of the grant of the patent: **26.12.2018**
(21) Application number: 15176707.6
(22) Date of filing: 14.07.2015
(51) Int. Cl.: H05K 3/28, C09D 11/101

(54) **MANUFACTURING PRINTED CIRCUIT BOARDS USING UV FREE RADICAL CURABLE INKJET INKS**
HERSTELLUNG VON GEDRUCKTEN LEITERPLATTEN UNTER VERWENDUNG VON UV-HÄRTBAREN TINTENSTRAHLTINTEN MIT FREIEN RADIKALEN
FABRICATION DE CARTES À CIRCUITS IMPRIMÉS À L'AIDE D'ENCRES POUR JET D'ENCRE DURCISSABLE PAR DES RADICAUX LIBRES D'UV

(43) Date of publication of application: 18.01.2017
(73) Proprietor: AGFA-GEVAERT, 2640 Mortsel (BE)
(72) Inventor: TORFS, Rita, 2640 Mortsel (BE); CANTERO, Gabriela, 2640 Mortsel (BE); LOCCUFIER, Johan, 2640 Mortsel (BE); VAN AERT, Hubertus, 2640 Mortsel (BE)
(74) Representative: Strijckers, Hans Louis P.

(56) References cited:
- CN-B- 102 492 330
- US-A- 4 668 601
- US-A1- 2004 106 707
- US-A1- 2008 090 930
- US-A1- 2011 143 047
- US-A1- 2015 064 417
- US-B1- 6 439 698

## Description

### Technical Field

The present invention relates to methods for manufacturing printed circuit boards (PCB), especially flexible printed circuits (Flex PCB), using UV curable inkjet inks.

### Background Art

Printed circuit boards have traditionally been made by photolithography. Lately, inkjet technology has been applied for manufacturing PCBs, due to its flexibility in use, such as the capability of variable data printing, and due to its enhanced reliability allowing their incorporation into production lines. UV curable inkjet inks are particularly preferred because high quality colour images can be printed on non-absorbing ink-receivers, such as plastic materials. For example, WO 2013/113572 (AGFA) discloses an UV curable etch-resist inkjet ink for manufacturing the conductive copper patterns on printed circuit boards.

A Flex PCB is a patterned arrangement of printed circuitry and components that utilizes a flexible substrate with or without flexible protective cover layer. These flexible electronic assemblies may be fabricated using the same components used for rigid printed circuit boards, but allowing the board to conform to a desired shape during its application. It offers the same advantages of a rigid printed circuit board: repeatability, reliability and high circuit density, but in addition also flexibility, weight reduction and high vibration resistance. As disadvantages, Flex PCBs are more easily damaged through improper handling (easy to bend and dent) and are more sensitive to scratching. Flex PCBs are advantageously used in applications such as mobile phones, notebook computers, LCD displays and instrumentation for aerospace, satellite, medical and automotive purposes.

It is known that an increased amount of monofunctional monomers in a UV curable inkjet ink results in enhanced flexibility and adhesion, however simultaneously the scratch resistance deteriorates. For improving scratch resistance, an increased amount of polyfunctional monomers is required. Adhesion problems are caused by the shrinkage of (meth)acrylate monomers, which are the most commonly used monomers in UV curable inkjet inks.

One approach to obtain optimal flexibility, adhesion and scratch resistance is to use cationically UV curable inkjet inks which employ monomers that do not shrink as the reactive monomers have oxetane and epoxy groups which cyclic structure is opened upon polymerization. For example, US 2006019077 (AVECIA) discloses a process for making a printed circuit board having a solder mask and area(s) of exposed metal circuitry which comprises the steps: a) applying a non-aqueous ink which is substantially free from organic solvent to a printed circuit board; b) curing the ink by exposure to actinic radiation; and c) optionally heating the ink; whereby the ink is applied to selected areas of the printed circuit board by means of an inkjet printer and wherein the ink comprises: i) a cationically curable compound; and ii) a cationic initiator. Among many others, hydroxy silane and silane acrylate are mentioned as adhesion promoters. However, it was found that cationically curable inkjet inks in industrial inkjet printing systems posed problems of jetting reliability due to UV stray light. UV stray light hitting the nozzle plate of an inkjet print head results into failing nozzles due to clogging by cured ink in the nozzle. Unlike free radical ink where radical species have a much shorter lifetime, the cationic curable ink continues to cure once an acid species has been generated by UV light in the nozzle.

Another approach is to use high amounts of up to 40% in the ink of monofunctional (meth)acrylate monomers for adhesion and flexibility and use a second curable system for scratch resistance. For example, US 2015064417 (TAIYO) discloses a photocurable and thermally curable inkjet ink for PCB manufacturing having excellent adhesion, chemical resistance, heat resistance, and insulating properties after curing. The inkjet ink includes a (meth)acryloyl group-containing monomer, a blocked isocyanate, and a photoinitiator, wherein the composition is applicable to inkjet printing. A wide range of coupling agents is disclosed as an additive, including silane coupling agents, titanate type coupling agents, zirconate type coupling agents and aluminate type coupling agents. However, until a thermal treatment is given to de-block and polymerize the blocked isocyanates, the inkjet printed image remains vulnerable to scratching.

A third approach is to balance the amount of monofunctional and polyfunctional monomers while selecting specific type of monomers. For example, US 2009056993 (CHISSO) and US 2008255297 (CHISSO) disclose the use of high viscous caprolactone modified polyfunctional monomers for forming a cured film with a balance of flame resistance, adhesion, chemical resistance, heat resistance, and softness (= poor scratch resistance). The use of such monomers result in high viscous UV curable inkjet inks, which have to be printed at very high jetting temperatures of 80 - 150°C or have to be diluted with large amounts of organic solvents or monofunctional monomers. Both measures result in poor scratch resistance and/or uneconomical an unreliable inkjet printing in an industrial environment.

Hence, there remains a need for improved manufacturing methods of Flex PCBs using UV curable inkjet inks which can be jetted at conventional jetting temperatures of about 40 to 45°C and which do not require any provisions for safe removal of organic solvents, for good flexibility, for good chemical and heat resistance and for good scratch resistance, while exhibiting good adhesion on a wide range of substrates including difficult substrates like polyimide.

CN 102 492 330 B discloses a UV curable inkjet ink containing a silane compound comprising an epoxy group and methoxy groups, but does not disclose using a blocked isocyanate compound and only discloses using a glass substrate.

### Summary of invention

In order to overcome the problems described above, preferred embodiments of the present invention provide manufacturing methods for printed circuit boards as claimed in claim 1.

Good adhesion and scratch resistance results on a polyimide substrate of a Flex PCB were obtained using a UV free radical inkjet ink having a specific composition including a specific silane compound. A cured layer of the UV free radical inkjet ink also provided good chemical resistance, such as good alkali resistance compared to the polyimide substrate which exhibits poor alkali resistance.

Further objects of the invention will become apparent from the description hereinafter.

### Brief description of drawings

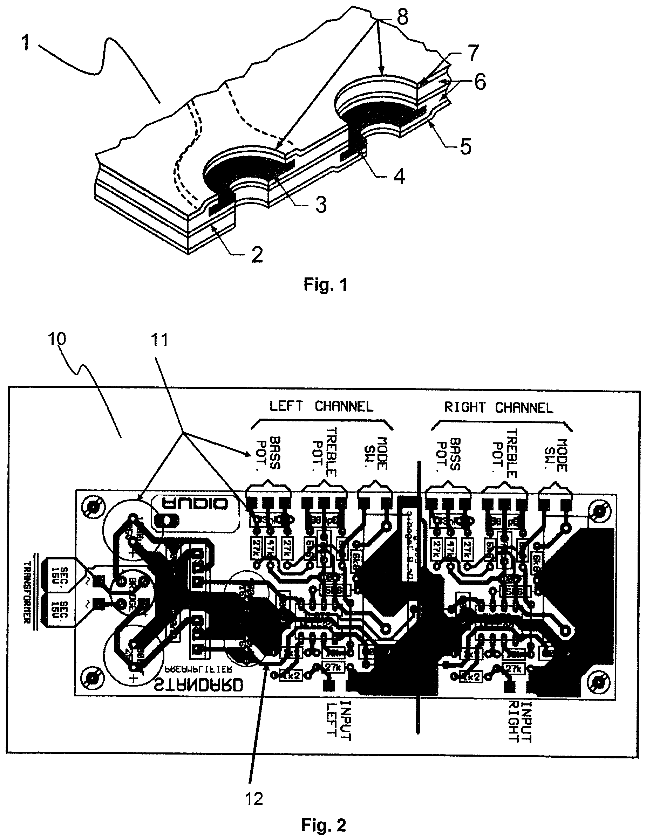

**Figure 1** shows a schematic representation of a multilayer Flex PCB (1) having a conductive pattern (3) and a second conductive pattern (4) on opposite sides of a polyimide substrate (2). An optional protective cover layer (7) is attached by an adhesive (6) to the polyimide substrate (2) and the conductive pattern (3) leaving access holes (8) in the protective cover layer (7), so that components, like a transistor, a resistor or a capacitor, may be soldered to accessible a copper pads of the conductive pattern (3).
**Figure 2** shows a top view of a PCB (10) having a conductive pattern (12) and component legend markings (11) to show which component goes where.

### Description of embodiments

### Definitions

The term "monofunctional monomer or oligomer" means a polymerizable compound including one ethylenically unsaturated polymerizable group.

The term "difunctional monomer or oligomer" means a polymerizable compound including two ethylenically unsaturated polymerizable groups.

The term "polyfunctional monomer or oligomer" means that the polymerizable compound includes more than two ethylenically unsaturated polymerizable groups, preferably three to six ethylenically unsaturated polymerizable groups.

The term "alkyl" means all variants possible for each number of carbon atoms in the alkyl group i.e. methyl, ethyl, for three carbon atoms: n-propyl and isopropyl; for four carbon atoms: n-butyl, isobutyl and tertiary-butyl; for five carbon atoms: n-pentyl, 1,1-dimethyl-propyl, 2,2-dimethylpropyl and 2-methyl-butyl, etc.

Unless otherwise specified a substituted or unsubstituted alkyl group is preferably a C₁ to C₆-alkyl group.

Unless otherwise specified a substituted or unsubstituted alkenyl group is preferably a C₁ to C₆-alkenyl group.

Unless otherwise specified a substituted or unsubstituted alkynyl group is preferably a C₁ to C₆-alkynyl group.

Unless otherwise specified a substituted or unsubstituted aralkyl group is preferably a phenyl or naphthyl group including one, two, three or more C₁ to C₆-alkyl groups.

Unless otherwise specified a substituted or unsubstituted alkaryl group is preferably a C₇ to C₂₀-alkyl group including a phenyl group or naphthyl group.

Unless otherwise specified a substituted or unsubstituted aryl group is preferably a phenyl group or naphthyl group

Unless otherwise specified a substituted or unsubstituted heteroaryl group is preferably a five- or six-membered ring substituted by one, two or three oxygen atoms, nitrogen atoms, sulphur atoms, selenium atoms or combinations thereof.

The term "substituted", in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms

Unless otherwise specified a substituted alkyl group, a substituted alkenyl group, a substituted alkynyl group, a substituted aralkyl group, a substituted alkaryl group, a substituted aryl and a substituted heteroaryl group are preferably substituted by one or more constituents selected from the group consisting of methyl, ethyl, n-propyl, isopropyl, n-butyl, isobutyl and tertiary-butyl, ester, amide, ether, thioether, ketone, aldehyde, sulfoxide, sulfone, sulfonate ester, sulphonamide, -CI, -Br, -I, -OH, -SH, - CN and -NO₂.

### Manufacturing Methods for PCBs

The manufacturing method for printed circuit boards according to the present invention is as defined in claim 1.

In a preferred embodiment of the manufacturing method, the jetting temperature used in the inkjet printing step a) is not higher than 55°C, more preferably between 35 to 50°C. The jetting temperature is the temperature to which the UV free radical curable inkjet ink is heated in a print head of an inkjet printing device.

A protective cover layer (5, 7) can be used and is selected from the group consisting of a polyimide layer, a polyether ether ketone (PEEK) layer and a polyester layer. The substrate (2) carrying the conductive pattern (3, 4) is a polyimide substrate.

A particularly preferred substrate is a polyimide substrate based on pyromellitic dianhydride and diaminophenyl ether, especially when a high temperature resistance is necessary, such as in a soldering process.

Commercially available polyimide substrates are Kapton™ series from DUPONT and Apical™ series from KANEKA.

In a preferred embodiment of the manufacturing method, the substrate is given a corona treatment before the inkjet printing step a). In a corona treatment, a voltage is applied between a discharge electrode and a counter electrode opposed to the discharge electrode to generate a discharge. The voltage applied to the discharge electrode can be an AC voltage or a DC voltage. In case of applying a DC voltage to the discharge electrode, a negative polarity is preferable. It is also possible to superpose an AC voltage with a DC voltage to be applied to the discharge electrode. The discharge is preferably generated in a state where the counter electrode is grounded. The discharge electrode can have a wire shape, a roll shape, a blade shape, a plate shape, a brush shape, a needle shape, or a bar shape. It is also preferable to bring the counter electrode into a contact with at least a part of the substrate. In order to cause the substrate to run, there is also preferably employed at least one conveying means selected from the group consisting of endless belt conveying, roll conveying, and drum conveying. It is further preferable that the conveying means have conductivity, thereby serving also as the counter electrode. The run may be run in a certain direction, reciprocating run, or a combination of them. The corona discharge can be incorporated in the inkjet printing device or it may be a separate device. If a separate device is used, the corona treatment is preferably given less than 1 hour before the inkjet printing step a). A suitable commercially available corona treatment machine is MULTIDYNE 1 (output; 800W, voltage; 2x12 kV) manufactured by 3DT Corporation. The distance to an electrode is preferably set at 5 mm, and treatment is preferably carried out at a speed of about 2 to 3 m/min.

The UV curing in step b) of the manufacturing method is preferably performed using ultraviolet LEDs, more preferably without using any mercury UV lamps, such as D-bulb or H-bulb..

The thermal treatment used in step c) of the manufacturing method preferably generates a temperature of at least 130°C, more preferably 140 to 160°C at the surface of the UV cured inkjet printed substrate.

### UV Free Radical Curable Inkjet Inks

A UV free radical curable inkjet ink according to the invention is as defined in claim 6.

In a preferred embodiment, the silane compound of Formula (I) has a linking group L represents an aliphatic chain having 4 to 6 carbon atoms optionally substituted in the aliphatic chain by a nitrogen or an oxygen.

In a preferred embodiment, R2 and R3 in the silane compound of Formula (I) both represent a methoxy group.

In a preferred embodiment, R4 in the silane compound of Formula (I) represents a functional group selected from the group consisting of an epoxy group and an amine group, more preferably R4 represents an epoxy group.

In a more preferred embodiment, R1 and R2 in the silane compound of Formula (I) represent a methoxy group, while R4 represents a functional group selected from the group consisting of an epoxy group and an amine group, more preferably R4 represents an epoxy group.

Suitable examples of silane compounds according to Formula (I) are given by Table 1, without being limited thereto.

**Table 1**

| | |
|---|---|
| SIL-1 | 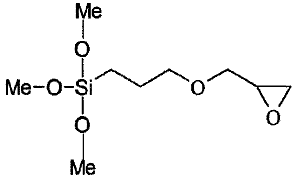 |
| SIL-2 | 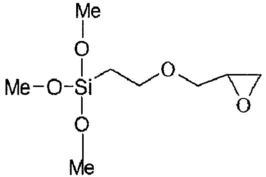 |
| SIL-3 | 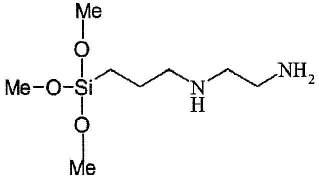 |
| SIL-4 | 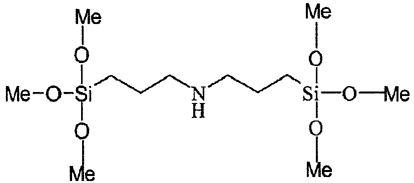 |
| SIL-5 | 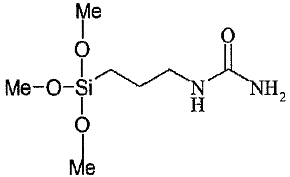 |
| SIL-6 | 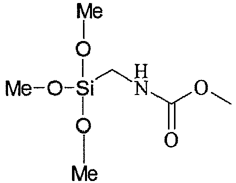 |
| SIL-7 | 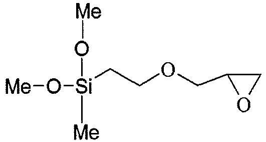 |
| SIL-8 | 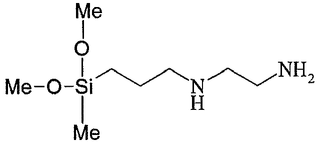 |
| SIL-9 | 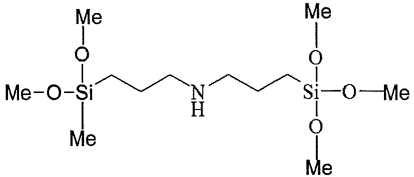 |
| SIL-10 | 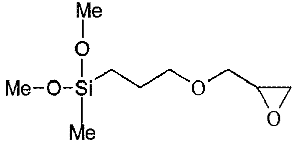 |
| SIL-11 | 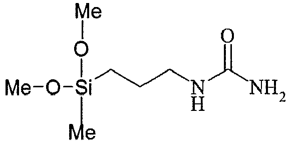 |

The UV free radical curable inkjet ink preferably includes 0 to 18 wt%, more preferably 0 to 8 wt% and most preferably 0 wt% of organic solvent based on the total weight of the inkjet ink. The UV free radical curable inkjet ink preferably doesn't contain an evaporable component as it reduces the reliability of inkjet printing due to reduced latency. Yet sometimes, it can be advantageous to incorporate a small amount of an organic solvent to aid in dissolving some compounds, e.g. photoinitiators, or to improve adhesion to the surface of the ink-receiver after UV-curing.

If an organic solvent is used, preferably the use of any carcinogenic solvents like toluene is avoided.

The UV free radical curable inkjet ink can be used alone, or in combination with other UV free radical curable inkjet inks. For example, the UV free radical curable inkjet ink may be part of an inkjet ink set. By using different colours, the information on a PCB becomes better legible.

The UV free radical curable inkjet ink may also be used as a solder mask inkjet ink. The use of a solder mask inkjet ink is known, for example, from EP 1543704 A (FUJIFILM).

The UV free radical curable inkjet ink preferably consists of difunctional and polyfunctional monomers and oligomers as polymerizable compounds.

The UV free radical curable inkjet ink preferably has a surface tension of 20 to 50 mN/m at 25°C, more preferably from 22 to 35 mN/m at 25°C.

The viscosity of the UV free radical curable inkjet ink is smaller than 90 mPa.s, and most preferably between 2 and 30 mPa.s at 25°C and at a shear rate of 1,000 s⁻¹.

For having a good ejecting ability, the viscosity of the radiation curable jettable composition or inkjet ink at the jetting temperature is preferably smaller than 35 mPa.s, more preferably smaller than 28 mPa.s, and most preferably between 1 and 20 mPa.s at a shear rate of 1,000 s⁻¹ and a jetting temperature between 20 and 65°C. The jetting temperature is preferably smaller than 65°C, more preferably smaller than 55°C and most preferably between 35 and 50°C.

The UV free radical curable inkjet ink contains preferably at least 55 wt%, more preferably at least 70 wt% of difunctional and polyfunctional monomers and oligomers, wherein the wt% is based on the total weight of the UV free radical curable inkjet ink.

The UV free radical curable inkjet ink preferably contains less than 10wt%, more preferably less than 9 wt%, and most preferably 0 to 8 wt% of a compound with a structure according to Formula (III): 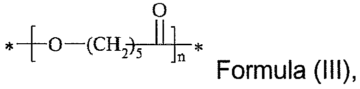 wherein n is an integer of 1-10 and wherein the wt% is based on the total weight of the UV free radical curable inkjet ink.

### Printed Circuit Boards

An embodiment of the invention is a printed circuit board carrying a cured image of a UV free radical curable inkjet ink according to the invention.

A preferred embodiment of such a printed circuit board is a flexible printed circuit board carrying a cured image of a UV free radical curable inkjet ink according to the invention. The advantage of the UV free radical curable inkjet ink according to the invention is that it can be used on both rigid and flexible printed circuit boards.

The UV free radical curable inkjet ink according to the invention is especially suited for providing component legend markings (11) on a PCB to show which component goes where. Such an inkjet ink for providing component legend markings is also known as a legend inkjet ink.

The UV free radical curable inkjet ink according to the invention is also suited as a protective cover layer. In such a case preferably, an inkjet ink set including at least two UV free radical curable inkjet inks according to the invention is used, wherein at least one is used as a legend inkjet ink.

### Difunctional Monomers and Oligomers

Any difunctional monomer or oligomer may be used as curable compound in the UV free radical curable inkjet ink according to the present invention. A combination of difunctional monomers and oligomers may also be used.

Preferred difunctional monomers and oligomers include triethylene glycol diacrylate, tetraethylene glycol diacrylate, polyethylene glycol diacrylate, dipropylene glycol diacrylate, tripropylene glycol diacrylate, polypropylene glycol diacrylate, 1,4-butanediol diacrylate, 1,6-hexanediol diacrylate, 1,9-nonanediol diacrylate, neopentyl glycol diacrylate, dimethyloltricyclodecane diacrylate, bisphenol A EO (ethylene oxide) adduct diacrylate, bisphenol A PO (propylene oxide) adduct diacrylate, hydroxypivalate neopentyl glycol diacrylate, propoxylated neopentyl glycol diacrylate, alkoxylated dimethyloltricyclodecane diacrylate and polytetramethylene glycol diacrylate, alkoxylated cyclohexanone dimethanol diacrylate, alkoxylated hexanediol diacrylate, dioxane glycol diacrylate, dioxane glycol diacrylate, cyclohexanone dimethanol diacrylate, diethylene glycol diacrylate and the like. Although less preferred because of lower curing speed, the methacrylate analogues of the above polyfunctional monomers and oligomers may also be used.

Particularly preferred difunctional monomers and oligomers include two different polymerizable groups, of which one is a (meth)acrylate group, more preferably an acrylate group. The other group is preferably selected from the group consisting of a vinylether group, a vinylester group, a vinylcarbonate group, an allylether group, an allylester group, an allyl carbonate group, a fumarate group and a maleate group. Such difunctional monomers and oligomers have a reactivity which is between that of a monofunctional acrylate and a difunctional acrylate monomer or oligomer. This results in a better compromise for adhesion/flexibility versus scratch resistance.

The most preferred difunctional monomers and oligomers are monomers and oligomers having one vinylether group and one (meth)acrylate group, more preferably monomers and oligomers having one vinylether group and one acrylate group.

The vinylether (meth)acrylate monomer is preferably a monomer represented by Formula (II): 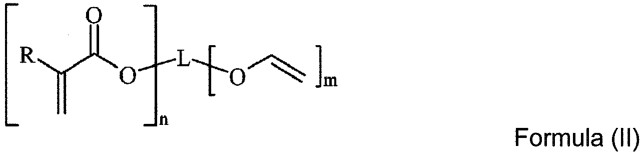 wherein,
R represents hydrogen or a methyl group;
L represents a linking group comprising at least one carbon atom; and
n and m independently represent a value of 1.

Suitable difunctional monomers and oligomers for the UV free radical curable inkjet ink according to the present invention are shown in Table 2, without being limited thereto.

**Table 2**

| | |
|---|---|
| DF-1 | 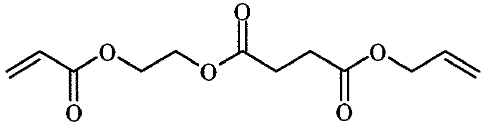 |
| DF-2 | 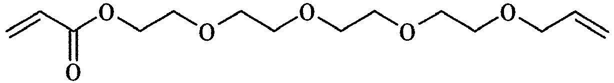 |
| DF-3 | 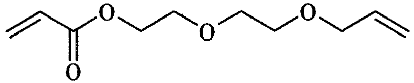 |
| DF-4 | 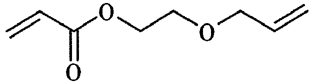 |
| DF-5 | 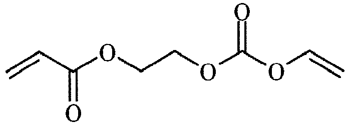 |
| DF-6 | 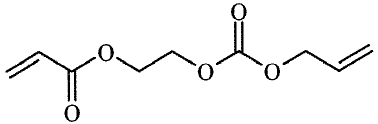 |
| DF-7 | 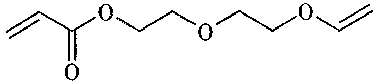 |
| DF-8 | 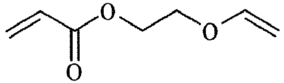 |
| DF-9 | 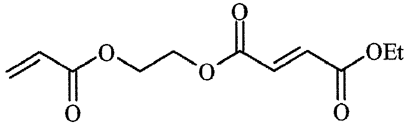 |
| DF-10 | 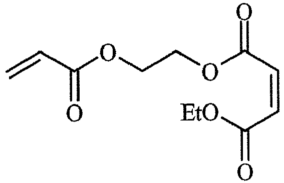 |
| DF-11 | |
| | 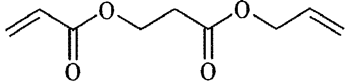 |
| DF-12 | 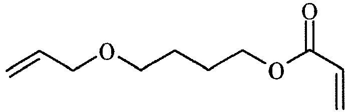 |
| DF-13 | 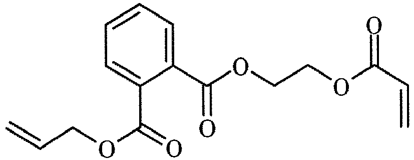 |
| DF-14 | 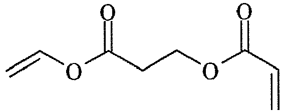 |
| DF-15 | 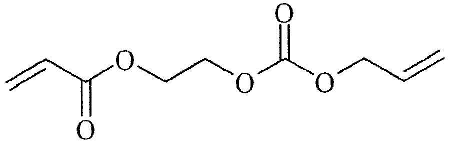 |

In the most preferred embodiment, the UV free radical curable inkjet ink contains 2-(2'-vinyloxyethoxy)ethyl acrylate as a difunctional monomer, as this monomer also provides a low visocosity to the inkjet ink.

The difunctional monomer or oligomer is preferably present in the UV free radical curable inkjet ink in an amount of 15 to 90 wt%, more preferably in an amount of 20 to 70 wt%, and most preferably in an amount of 25 to 60 wt%, all based on the total weight of the UV free radical curable inkjet ink.

### Polyfunctional Monomers and Oligomers

Any polyfunctional monomer or oligomer may be used as curable compound in the UV free radical curable inkjet ink according to the present invention. A combination of polyfunctional monomers and oligomers may also be used. The monomers and oligomers may possess different degrees of functionality, and a mixture including combinations of tri-, four-, five- and higher functionality monomers and oligomers may be used. The viscosity of the inkjet ink can be advantageously adjusted by varying the ratio between the difunctional and polyfunctional monomers and oligomers.

Preferred polyfunctional monomers and oligomers include trimethylolpropane triacrylate, EO modified trimethylolpropane triacrylate, tri (propylene glycol) triacrylate, caprolactone modified trimethylolpropane triacrylate, pentaerythritol triacrylate, pentaerithritol tetraacrylate, pentaerythritolethoxy tetraacrylate, dipentaerythritol hexaacrylate, ditrimethylolpropane tetraacrylate and glycerinpropoxy triacrylate. Although less preferred because of lower curing speed, the methacrylate analogues of the above polyfunctional monomers and oligomers may also be used.

A preferred polyfunctional monomer or oligomer is a vinylether (meth)acrylate monomer represented by Formula (IIb): 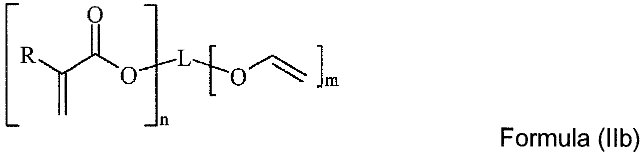 wherein,
R represents hydrogen or a methyl group;
L represents a linking group comprising at least one carbon atom; and
n and m independently represent a value from 1 to 5, with the proviso that the sum n+m is at least 3.

The polyfunctional monomer or oligomer is preferably present in the UV free radical curable inkjet ink in an amount of 15 to 90 wt%, more preferably in an amount of 20 to 70 wt%, and most preferably in an amount of 25 to 60 wt%, all based on the total weight of the UV free radical curable inkjet ink.

### Monofunctional Monomers and Oligomers

Monofunctional monomers and oligomers tend to improve adhesion and flexibility, but reduce scratch resistance.

The UV free radical curable inkjet ink according to the present invention may contain 0 to 9 wt%, preferably 0 to 8 wt%, more preferably 0 to 5 wt%, and most preferably 0 wt% of a monofunctional monomer or oligomer based on the total weight of the UV free radical curable inkjet ink.

An amount higher than 8 or 9 wt% usually reduces the scratch resistance to an undesired level.

Suitable monofunctional monomers include caprolactone acrylate, cyclic trimethylolpropane formal acrylate, ethoxylated nonyl phenol acrylate, isodecyl acrylate, isooctyl acrylate, octyldecyl acrylate, alkoxylated phenol acrylate, tridecyl acrylate, isoamyl acrylate, stearyl acrylate, lauryl acrylate, octyl acrylate, decyl acrylate, isoamylstyl acrylate, isostearyl acrylate, 2-ethylhexyl-diglycol acrylate, 2-hydroxybutyl acrylate, 2-acryloyloxyethylhexahydrophthalic acid, butoxyethyl acrylate, ethoxydiethylene glycol acrylate, methoxydiethylene glycol acrylate, methoxypolyethylene glycol acrylate, methoxypropylene glycol acrylate, phenoxyethyl acrylate, tetrahydrofurfuryl acrylate, isobornyl acrylate, 2-hydroxyethyl acrylate, 2-hydroxypropyl acrylate, 2-hydroxy-3-phenoxypropyl acrylate, 2-acryloyloxyethylsuccinic acid, 2-acryloyxyethylphthalic acid, 2-acryloxyethyl-2-hydroxyethyl-phthalic acid, lactone modified flexible acrylate, ethoxyethoxyethylacrylate, 2 phenoxyethyl acrylate, N-vinyl caprolactam and t-butylcyclohexyl acrylate.

Other suitable monofunctional acrylates include caprolactone acrylate, cyclic trimethylolpropane formal acrylate, ethoxyethoxyethylmethacrylate, ethoxylated nonyl phenol acrylate, isodecyl acrylate, isooctyl acrylate, octyldecyl acrylate, alkoxylated phenol acrylate, and tridecyl acrylate.

Preferred monofunctional acrylates are tetrahydrofurfuryl methacrylate, alkyl acrylate (preferably a C₁₂ to C₁₅ alkyl acrylate), ethoxyethoxyethylacrylate, 2 phenoxyethyl acrylate, ethoxylated-4-phenyl acrylate, and 3,3,5 trimethyl cyclohexanol methoxy polyethylene glycol (350) acrylate.

### Blocked Isocyanate Compounds

The UV free radical curable inkjet ink preferably contains a blocked isocyanate compound. Blocked isocyanate compounds are compounds formed by the reaction of an isocyanate compound with an active hydrogen compound, the latter known as a blocking agent. The reaction is reversible with moderate heat treatment. The blocked isocyanate can be used in formulations in the presence of materials that normally would react rapidly with isocyanates.

In the present invention, the blocked isocyanate compound may be an aliphatic/alicyclic isocyanate compound or an aromatic isocyanate compound.

In a preferred embodiment of the present invention, the blocked isocyanate compound is preferably blocked polyfunctional isocyanate compound. When a blocked polyfunctional isocyanate is used, it results in a network structure bearing a triazine skeleton, which improves heat resistance and chemical resistance.

Suitable blocking agents include alcohols such as ethanol, n-propanol, isopropanol, t-butanol, and isobutanol; phenols such as phenol, chlorophenol, cresol, xylenol, and p-nitrophenol; alkylphenols such as p-t-butylphenol, p-sec-butylphenol, p-sec-amylphenol, p-octylphenol, and p-nonylphenol; basic nitrogen-containing compounds such as 3-hydroxypyridine, 8-hydroxyquinoline, and 8-hydroxyquinaldine; active methylene compounds such as diethyl malonate, ethyl acetoacetate, and acetylacetone; acid amides such as acetamide, acrylamide, and acetanilide, acid imides such as succinimide and maleic imide; imidazoles such as 2-ethylimidazole and 2-ethyl-4-methylimidazole; pyrazoles such as pyrazole, 3-methylpyrazole, and 3,5-dimethylpyrazole; lactams such as 2-pyrrolidone and 8-caprolactam; oximes of ketone or aldehyde, such as acetoxime, methyl ethyl ketone oxime, cyclohexanone oxime, and acetaldoxime; ethyleneimine; and bisulfite.

In the present invention, the blocked isocyanate compound is preferably blocked by a blocking agent selected from the group consisting of an active methylene compound and a pyrazoles more preferably blocked by a blocking agent selected from the group consisting of diethyl malonate and 3,5-dimethylpyrazole, and a blocked isocyanate compound blocked by 3,5-dimethylpyrazole being particularly preferable.

The blocking agent may be used singly or in combinations of two or more.

Preferred isocyanate compounds that are blocked by the above blocking agents are aliphatic/alicyclic isocyanates and aromatic isocyanates.

Preferred aliphatic/alicyclic isocyanate compounds to be blocked include 1,6-hexamethylene diisocyanate (HDI or HMDI), isophorone diisocyanate (IPDI), methylcyclohexane 2,4-(2,6)-diisocyanate (hydrogenated TDI), 4,4'-methylenebis(cyclohexylisocyanate) (hydrogenated MDI), 1,3-(isocyanatomethyl)cyclohexane (hydrogenated XDI), norbornene diisocyanate (NDI), lysine diisocyanate (LDI), trimethylhexamethylene diisocyanate (TMDI), dimer acid diisocyanate (DDI), and N,N',N"-tris(6-isocyanate-hexamethylene)biuret.

Preferred aromatic isocyanate compounds to be blocked include, tolylene diisocyanate (TDI), 4,4'-diphenylmethane diisocyanate (MDI), and xylylene diisocyanate (XDI).

Besides the above isocyanate compounds, a trimer of 1,6-hexamethylene diisocyanate and a trimer of isophorone diisocyanate may also be used.

One, two or more blocked isocyanate compounds may be used in the UV free radical curable inkjet ink of the invention.

Preferred block isocyanate compounds have a viscosity at 25°C of smaller than 2,000 mPa.s, preferably smaller than 1,000 mPa.s

Suitable commercially available blocked isocyanate compounds include BI7982 and BI7992 from Baxenden Chemicals Ltd.

The amount of the blocked isocyanate compound is preferably 1 to 40 wt%, more preferably 2 to 25 wt% based on the total weight of the UV free radical curable inkjet ink. Higher amounts than 40 wt% tend to render the ultraviolet curing properties insufficient.

### Free Radical Photoinitiators

The UV free radical curable inkjet ink according to the invention includes at least one free radical photoinitiator, however for increasing curing speed the UV free radical curable inkjet ink preferably contains a free radical photoinitiating system including one or more free radical photoinitiators and optionally one or more co-initiators. A free radical photoinitiator is a chemical compound that initiates polymerization of monomers and oligomers when exposed to actinic radiation by the formation of a free radical. The photoinitiating system is preferably free of cationic photoinitiators.

Two types of free radical photoinitiators can be distinguished and used in the inkjet ink of the present invention. A Norrish Type I initiator is an initiator which cleaves after excitation, yielding the initiating radical immediately. A Norrish type II-initiator is a photoinitiator which is activated by actinic radiation and forms free radicals by hydrogen abstraction from a second compound that becomes the actual initiating free radical. This second compound is called a polymerization synergist or co-initiator. Both type I and type II photoinitiators can be used in the present invention, alone or in combination.

Suitable photo-initiators are disclosed in CRIVELLO, J.V., et al. VOLUME III: Photoinitiators for Free Radical Cationic . 2nd edition. Edited by BRADLEY, G.. London,UK: John Wiley and Sons Ltd, 1998. p.287-294.

Specific examples of photo-initiators may include, but are not limited to, the following compounds or combinations thereof: benzophenone and substituted benzophenones, 1-hydroxycyclohexyl phenyl ketone, thioxanthones such as isopropylthioxanthone, 2-hydroxy-2-methyl-1-phenylpropan-1-one, 2-benzyl-2-dimethylamino- (4-morpholinophenyl) butan-1-one, benzil dimethylketal, bis (2,6- dimethylbenzoyl) -2,4, 4-trimethylpentylphosphine oxide, 2,4,6trimethylbenzoyldiphenylphosphine oxide, 2-methyl-1- [4- (methylthio) phenyl] -2-morpholinopropan-1-one, 2,2-dimethoxy-1, 2-diphenylethan-1-one or 5,7-diiodo-3- butoxy-6-fluorone.

Suitable commercial photo-initiators include Irgacure™ 184, Irgacure™ 500, Irgacure™ 907, Irgacure™ 369, Irgacure™ 1700, Irgacure™ 651, Irgacure™ 819, Irgacure™ 1000, Irgacure™ 1300, Irgacure™ 1870, Darocur™ 1173, Darocur™ 2959, Darocur™ 4265 and Darocur™ ITX available from CIBA SPECIALTY CHEMICALS, Lucerin™ TPO available from BASF AG, Esacure™ KT046, Esacure™ KIP150, Esacure™ KT37 and Esacure™ EDB available from LAMBERTI, H-Nu™ 470 and H-Nu™ 470X available from SPECTRA GROUP Ltd..

In a particularly preferred embodiment, the UV free radical curable inkjet ink includes an acyl phosphine oxide type photoinitiator or a bisacyl phosphine oxide type photoinitiator.

In a preferred embodiment, the photoinitiator is selected from the group consisting of non-polymeric multifunctional photoinitiators, oligomeric or polymeric photoinitiators and polymerizable photoinitiators. Such a diffusion hindered photoinitiator exhibits a much lower mobility in a cured layer of the UV curable inkjet inks than a low molecular weight monofunctional photoinitiator, such as benzophenone. Including diffusion hindered photoinitiators, and also diffusion hindered co-initiators if any, offer a safety advantage for the health of the operator of the inkjet printer.

Most preferably the diffusion hindered photoinitiator is a polymerizable photoinitiator, preferably having at least one acrylate group.

Suitable diffusion hindered photoinitiator may contain one or more photoinitiating functional groups derived from a Norrish type I-photoinitiator selected from the group consisting of benzoinethers, benzil ketals, α,α-dialkoxyacetophenones, α-hydroxyalkylphenones, α-aminoalkylphenones, acylphosphine oxides, acylphosphine sulfides, α-haloketones, α-halosulfones and phenylglyoxalates.

A suitable diffusion hindered photoinitiator may contain one or more photoinitiating functional groups derived from a Norrish type II-initiator selected from the group consisting of benzophenones, thioxanthones, 1,2-diketones and anthraquinones.

Suitable diffusion hindered photoinitiators are also those disclosed in EP 2053101 A (AGFA GRAPHICS) in paragraphs [0074] and [0075] for difunctional and multifunctional photoinitiators, in paragraphs [0077] to [0080] for polymeric photoinitiators and in paragraphs [0081] to [0083] for polymerizable photoinitiators.

Other preferred polymerizable photoinitiators are those disclosed in EP 2065362 A (AGFA) and EP 2161264 A (AGFA), incorporated herein by reference.

A preferred amount of photoinitiator is 0 - 50 wt%, more preferably 0.1 - 20 wt%, and most preferably 0.3 - 15 wt% of the total weight of the curable pigment dispersion or ink.

In order to increase the photosensitivity further, the UV curable inkjet ink may additionally contain co-initiators. Preferred co-initiators can be categorized in three groups:
1. tertiary aliphatic amines such as methyldiethanolamine, dimethylethanolamine, triethanolamine, triethylamine and N-methylmorpholine;
2. aromatic amines such as amylparadimethylaminobenzoate, 2-n-butoxyethyl-4-(dimethylamino) benzoate, 2-(dimethylamino)ethylbenzoate, ethyl-4-(dimethylamino)benzoate, and 2-ethylhexyl-4-(dimethylamino)benzoate; and
3. (meth)acrylated amines such as dialkylamino alkyl(meth)acrylates (e.g., diethylaminoethylacrylate) or N-morpholinoalkyl-(meth)acrylates (e.g., N-morpholinoethyl-acrylate).
   The most preferred co-initiators are aminobenzoates.

Preferred diffusion hindered co-initiators are the polymerizable co-initiators disclosed in EP 2053101 A (AGFA GRAPHICS) in paragraphs [0088] and [0097].

Preferred diffusion hindered co-initiators include a polymeric co-initiator having a dendritic polymeric architecture, more preferably a hyperbranched polymeric architecture. Preferred hyperbranched polymeric co-initiators are those disclosed in US 2006014848 (AGFA) incorporated herein as a specific reference.

Most preferably the diffusion hindered co-initiator is a polymerizable co-initiator, preferably having at least one acrylate group.

The UV curable ink preferably comprises the diffusion hindered co-initiator in an amount of 0.1 to 50 wt%, more preferably in an amount of 0.5 to 25 wt%, most preferably in an amount of 1 to 10 wt% of the total weight of the ink.

### Polymerization Inhibitors

The UV free radical curable inkjet ink according to the invention may contain a polymerization inhibitor. Suitable polymerization inhibitors include phenol type antioxidants, hindered amine light stabilizers, phosphor type antioxidants, hydroquinone monomethyl ether commonly used in (meth)acrylate monomers, and hydroquinone, t-butylcatechol, pyrogallol may also be used.

Suitable commercial inhibitors are, for example, Sumilizer™ GA-80, Sumilizer™ GM and Sumilizer™ GS produced by Sumitomo Chemical Co. Ltd.; Genorad™ 16, Genorad™ 18 and Genorad™ 20 from Rahn AG; Irgastab™ UV10 and Irgastab™ UV22, Tinuvin™ 460 and CGS20 from Ciba Specialty Chemicals; Floorstab™ UV range (UV-1, UV-2, UV-5 and UV-8) from Kromachem Ltd, Additol™ S range (S100, S110, S120 and S130) from Cytec Surface Specialties.

Since excessive addition of these polymerization inhibitors will lower the ink sensitivity to curing, it is preferred that the amount capable of preventing polymerization is determined prior to blending. The amount of a polymerization inhibitor is preferably lower than 2 wt% based on the total weight of the inkjet ink.

### Colorants

The UV free radical curable inkjet ink according to the invention includes at least one colorant, preferably a colour pigment.

The colour pigments may be black, cyan, magenta, yellow, red, orange, violet, blue, green, brown, mixtures thereof, and the like. A colour pigment may be chosen from those disclosed by HERBST, Willy, et al. Industrial Organic Pigments, Production, Properties, Applications. 3rd edition. Wiley - VCH , 2004. ISBN 3527305769.

However, most preferably the UV free radical curable inkjet ink includes a colorant selected from the group consisting of a white pigment, a yellow pigment and a black pigment. It was observed that the component legend markings (11) on a generally green coloured protective cover layer (5, 7) is best legible when using a white, yellow or black colour, especially a white colour. For this reason, the UV free radical curable inkjet ink preferably includes a titanium dioxide pigment as white pigment.

Particularly preferred pigments for yellow inkjet inks are C.I Pigment Yellow 151, C.I. Pigment Yellow 180 and C.I. Pigment Yellow 74, and mixed crystals thereof.

For a black inkjet ink, suitable pigment materials include carbon blacks such as Regal™ 400R, Mogul™ L, Elftex™ 320 from Cabot Co., or Carbon Black FW18, Special Black™ 250, Special Black™ 350, Special Black™ 550, Printex™ 25, Printex™ 35, Printex™ 55, Printex™ 90, Printex™ 150T from DEGUSSA Co., MA8 from MITSUBISHI CHEMICAL Co., and C.I. Pigment Black 7 and C.I. Pigment Black 11.

For a black inkjet ink, preferably a combination of a carbon black pigment and at least one pigment selected from the group consisting of a blue pigment, a cyan pigment, a magenta pigment and a red pigment. It was found that the legibility of component legend markings on a PCB were further improved using such a black inkjet ink. In a particularly preferred embodiment of such a black inkjet ink, a pigment is selected from the group consisting of C.I. Pigment Blue 15:3, C.I. Pigment Blue 15:4, a diketopyrrolo pyrrole pigment (e.g. C.I Pigment Red 254), a quinacridone pigment (e.g. C.I. Pigment Violet 19, C.I. Pigment Red 202, and C.I. Pigment Red 122), and mixed crystals of quinacridone pigments and/or diketopyrrolo pyrrole pigments.

The pigment particles in the inkjet ink should be sufficiently small to permit free flow of the ink through the inkjet printing device, especially at the ejecting nozzles. It is also desirable to use small particles for maximum colour strength and to slow down sedimentation.

The average particle size of the pigment in the inkjet ink should be between 0.02 µm and 3 µm. Preferably the average pigment particle size is between 0.05 and 1 µm, more preferably between 0.070 and 0.300 µm, particularly preferably between 0.80 and 0.200 µm and most preferably between 0.090 and 0.150 µm.

The pigment is used in the inkjet ink in an amount of 0.1 to 20 wt%, preferably 1 to 10 wt%, and most preferably 2 to 6 wt% based on the total weight of the pigmented inkjet ink.

A white inkjet ink preferably includes a pigment with a high refractive index, preferably a refractive index greater than 1.60, preferably greater than 2.00, more preferably greater than 2.50 and most preferably greater than 2.60. Such white pigments generally have a very covering power, i.e. a limited amount of white ink is necessary to hide the colour and defects of the core layer. The most preferred white pigment is titanium dioxide.

The white inkjet ink preferably contains the white pigment in an amount of 5 wt% to 30 wt%, more preferably 8 to 25 wt% of white pigment based upon the total weight of the white inkjet ink.

The numeric average particle diameter of the white pigment is preferably from 150 to 500 nm, more preferably from 200 to 400 nm, and most preferably from 250 to 350 nm. Sufficient hiding power cannot be obtained when the average diameter is less than 150 nm, and the storage ability and the jet-out suitability of the ink tend to be degraded when the average diameter exceeds 500 nm.

### Polymeric Dispersants

Typical polymeric dispersants are copolymers of two monomers but may contain three, four, five or even more monomers. The properties of polymeric dispersants depend on both the nature of the monomers and their distribution in the polymer. Copolymeric dispersants preferably have the following polymer compositions:
- statistically polymerized monomers (e.g. monomers A and B polymerized into ABBAABAB);
- alternating polymerized monomers (e.g. monomers A and B polymerized into ABABABAB);
- gradient (tapered) polymerized monomers (e.g. monomers A and B polymerized into AAABAABBABBB);
- block copolymers (e.g. monomers A and B polymerized into AAAAABBBBBB) wherein the block length of each of the blocks (2, 3, 4, 5 or even more) is important for the dispersion capability of the polymeric dispersant;
- graft copolymers (graft copolymers consist of a polymeric backbone with polymeric side chains attached to the backbone); and
- mixed forms of these polymers, e.g. blocky gradient copolymers.

Suitable polymeric dispersants are listed in the section on "Dispersants", more specifically [0064] to [0070] and [0074] to [0077], in EP 1911814 A (AGFA GRAPHICS) incorporated herein as a specific reference.

The polymeric dispersant has preferably a number average molecular weight Mn between 500 and 30000, more preferably between 1500 and 10000.

The polymeric dispersant has preferably a weight average molecular weight Mw smaller than 100,000, more preferably smaller than 50,000 and most preferably smaller than 30,000.

The polymeric dispersant has preferably a polydispersity PD smaller than 2, more preferably smaller than 1.75 and most preferably smaller than 1.5.

Commercial examples of polymeric dispersants are the following:
- DISPERBYK™ dispersants available from BYK CHEMIE GMBH;
- SOLSPERSE™ dispersants available from LUBRIZOL;
- TEGO™ DISPERS™ dispersants from EVONIK;
- EDAPLAN™ dispersants from MÜNZING CHEMIE;
- ETHACRYL™ dispersants from LYONDELL;
- GANEX™ dispersants from ISP;
- DISPEX™ and EFKA™ dispersants from BASF;
- DISPONER™ dispersants from DEUCHEM.

Particularly preferred polymeric dispersants include Solsperse™ dispersants from LUBRIZOL, Efka™ dispersants from BASF and Disperbyk™ dispersants from BYK CHEMIE GMBH. Particularly preferred dispersants are Solsperse™ 32000, 35000 and 39000 dispersants from LUBRIZOL.

The polymeric dispersant is preferably used in an amount of 2 to 600 wt%, more preferably 5 to 200 wt%, most preferably 50 to 90 wt% based on the weight of the pigment.

### Surfactants

Surfactants are used in inkjet inks to reduce the surface tension of the ink. In the case of UV curable inkjet inks, however, the surface tension of the inkjet ink is not only determined by the amount and type of surfactant, but also by the polymerizable compounds, the polymeric dispersants and other additives in the ink composition.

The surfactant(s) can be anionic, cationic, non-ionic, or zwitter-ionic and may be added in a total quantity less than 20 wt% based on the total weight of the inkjet ink and particularly in a total less than 10 wt% based on the total weight of the inkjet ink. However, preferably no surfactant is present for maximizing resolution and image quality.

Suitable surfactants include fluorinated surfactants, fatty acid salts, ester salts of a higher alcohol, alkylbenzene sulphonate salts, sulphosuccinate ester salts and phosphate ester salts of a higher alcohol (for example, sodium dodecylbenzenesulphonate and sodium dioctylsulphosuccinate), ethylene oxide adducts of a higher alcohol, ethylene oxide adducts of an alkylphenol, ethylene oxide adducts of a polyhydric alcohol fatty acid ester, and acetylene glycol and ethylene oxide adducts thereof (for example, polyoxyethylene nonylphenyl ether, and SURFYNOL™ 104, 104H, 440, 465 and TG available from AIR PRODUCTS & CHEMICALS INC.).

Preferred surfactants include fluoro surfactants (such as fluorinated hydrocarbons) and silicone surfactants. The silicones are typically siloxanes and can be alkoxylated, polyether modified, polyester modified, polyether modified hydroxy functional, amine modified, epoxy modified and other modifications or combinations thereof. Preferred siloxanes are polymeric, for example polydimethylsiloxanes.

The fluorinated or silicone compound used as a surfactant may be a crosslinkable surfactant. Suitable copolymerizable compounds having surface-active effects include, for example, polyacrylate copolymers, silicone modified acrylates, silicone modified methacrylates, acrylated siloxanes, polyether modified acrylic modified siloxanes, fluorinated acrylates, and fluorinated methacrylate. These acrylates can be mono-, di-, tri- or higher functional (meth)acrylates.

Depending upon the application a surfactant can be used with a high, low or intermediate dynamic surface tension. Silicone surfactants are generally known to have low dynamic surface tensions while fluorinated surfactants are known to have higher dynamic surface tensions.

Silicone surfactants are often preferred in curable inkjet inks, especially the reactive silicone surfactants, which are able to be polymerized together with the polymerizable compounds during the curing step.

Examples of useful commercial silicone surfactants are those supplied by BYK CHEMIE GMBH (including Byk™-302, 307, 310, 331, 333, 341, 345, 346, 347, 348, UV3500, UV3510 and UV3530), those supplied by TEGO CHEMIE SERVICE (including Tego Rad™ 2100, 2200N, 2250, 2300, 2500, 2600 and 2700), Ebecryₗ™ 1360 a polysilixone hexaacrylate from CYTEC INDUSTRIES BV and Efka™-3000 series (including Efka™-3232 and Efka™-3883) from EFKA CHEMICALS B.V..

### Preparation of Inkjet Inks

The preparation of pigmented UV curable inkjet inks is well-known to the skilled person. Preferred methods of preparation are disclosed in paragraphs [0076] to [0085] of WO 2011/069943 (AGFA).

### Inkjet Printing Devices

The inkjet inks may be jetted by one or more print heads ejecting small droplets of ink in a controlled manner through nozzles onto an ink-receiving surface (e.g. a protective cover layer), which is moving relative to the print head(s).

A preferred print head for the inkjet printing system is a piezoelectric head. Piezoelectric inkjet printing is based on the movement of a piezoelectric ceramic transducer when a voltage is applied thereto. The application of a voltage changes the shape of the piezoelectric ceramic transducer in the print head creating a void, which is then filled with ink. When the voltage is again removed, the ceramic expands to its original shape, ejecting a drop of ink from the print head. However the manufacturing method according to the present invention is not restricted to piezoelectric inkjet printing. Other inkjet print heads can be used and include various types, such as a continuous type and thermal, electrostatic and acoustic drop on demand type.

The inkjet print head normally scans back and forth in a transversal direction across the moving ink-receiving surface. Often the inkjet print head does not print on the way back. Bi-directional printing is preferred for obtaining a high areal throughput. Another preferred printing method is by a "single pass printing process", which can be performed by using page wide inkjet print heads or multiple staggered inkjet print heads which cover the entire width of the ink-receiver surface. In a single pass printing process the inkjet print heads usually remain stationary and the substrate surface is transported under the inkjet print heads.

### UV Curing Devices

The UV curable inkjet inks are cured by exposing them to ultraviolet radiation. The curing means may be arranged in combination with the print head of the inkjet printer, travelling therewith so that the curable inkjet ink is exposed to curing radiation very shortly after been jetted.

In such an arrangement it can be difficult to provide a small enough radiation source connected to and travelling with the print head. Therefore, a static fixed radiation source may be employed, e.g. a source of curing UV-light, connected to the radiation source by means of flexible radiation conductive means such as a fibre optic bundle or an internally reflective flexible tube.

Alternatively, the actinic radiation may be supplied from a fixed source to the radiation head by an arrangement of mirrors including a mirror upon the radiation head.

The source of radiation arranged not to move with the print head, may also be an elongated radiation source extending transversely across the ink-receiver surface to be cured and adjacent the transverse path of the print head so that the subsequent rows of images formed by the print head are passed, stepwise or continually, beneath that radiation source.

Any ultraviolet light source, as long as part of the emitted light can be absorbed by the photo-initiator or photo-initiator system, may be employed as a radiation source, such as, a high or low pressure mercury lamp, a cold cathode tube, a black light, an ultraviolet LED, an ultraviolet laser, and a flash light. Of these, the preferred source is one exhibiting a relatively long wavelength UV-contribution having a dominant wavelength of 300-400 nm. Specifically, a UV-A light source is preferred due to the reduced light scattering therewith resulting in more efficient interior curing.

UV radiation is generally classed as UV-A, UV-B, and UV-C as follows:
- UV-A: 400 nm to 320 nm
- UV-B: 320 nm to 290 nm
- UV-C: 290 nm to 100 nm.

Furthermore, it is possible to cure the image using, consecutively or simultaneously, two light sources of differing wavelength or illuminance. For example, the first UV-source can be selected to be rich in UV-C, in particular in the range of 260 nm-200 nm. The second UV-source can then be rich in UV-A, e.g. a gallium-doped lamp, or a different lamp high in both UV-A and UV-B. The use of two UV-sources has been found to have advantages e.g. a fast curing speed and a high curing degree.

For facilitating curing, the inkjet printer often includes one or more oxygen depletion units. The oxygen depletion units place a blanket of nitrogen or other relatively inert gas (e.g. CO₂), with adjustable position and adjustable inert gas concentration, in order to reduce the oxygen concentration in the curing environment. Residual oxygen levels are usually maintained as low as 200 ppm, but are generally in the range of 200 ppm to 1200 ppm.

In the most preferred embodiment of the manufacturing method according to the present invention, the UV curing in step b) is performed using ultraviolet LEDs.

### Heating Devices

The inkjet printer may contain a thermal curing device for improving adhesion by giving a thermal treatment, alternatively the heat treatment may be given off-line.

The heating device may be a heart convection device like an oven, an infrared radiation source as described here below, or may be a heat conduction device, such as a hot plate or a heat drum. A preferred heat drum is an induction heat drum.

A preferred thermal curing device uses Carbon Infrared Radiation (CIR) to heat the outside of the substrate quickly. Another preferred thermal curing device is a NIR source emitting near infrared radiation. NIR-radiation energy quickly enters into the depth of the inkjet ink layer, while conventional infrared and thermo-air energy predominantly is absorbed at the surface and slowly conducted into the ink layer.

The thermal curing device may be, at least in part, arranged in combination with the print head of the inkjet printer, travelling therewith so that the curing radiation is applied very shortly after jetting together or after UV irradiation. In such a case, the inkjet printer is preferably equipped with some kind of infrared radiation source, e.g. an infrared light source, such as an infrared laser, one or more infrared laser diodes or infrared LEDs.

A preferred effective infrared radiation source has an emission maximum between 0.8 and 1.5 µm. Such an infrared radiation source is sometimes called a NIR radiation source or NIR dryer. In a preferred form the NIR radiation source is in the form of NIR LEDs, which can be mounted easily on a shuttling system of a plurality of inkjet print heads in a multi-pass inkjet printing device.

In a more preferred form the NIR radiation source is mounted downstream of single pass inkjet printing device.

### Examples

### Materials

All materials used in the following examples were readily available from standard sources such as Sigma-Aldrich (Belgium) and Acros (Belgium) unless otherwise specified.
**SIL-1** is an epoxy substituted trimethoxy silane available as Silane™ Z6040 from DOW CORNING.
**SIL-1B** is an epoxy substituted trimethoxy silane identical to SIL-1 but available as Dynasylan™ Glymo from EVONIK.
**SIL-3** is an amine substituted trimethoxy silane available as Geniosil™ GF9 from Wacker Chemie AG.
**SIL-4** is a bis-trimethoxysilane available as Silquest™ A-1170 from Momentive Performance Materials Inc.
**SIL-5** is an ureido substituted trimethoxy silane available as Silquest™ A-1524 from Momentive Performance Materials Inc.
**SIL-6** is a carbamate substituted trimethoxy silane available as Geniosil™ XL63 from Wacker Chemie AG.
**CSIL-1** is a methacrylate silane available as Geniosil™ XL33 from Wacker Chemie AG.
**CSIL-2** is an epoxy substituted diethoxy silane available as Coatosil™ 2287 from Momentive Performance Materials Inc.
**CSIL-3** is 3-methacryloxypropyltrimethoxysilane.
**CSIL-4** is an epoxy substituted triethoxy silane available as Geniosil™ GF82 from Wacker Chemie AG.
**CSIL-5** is an epoxy silane available as Coatosil™ 1770 from Momentive Performance Materials Inc.
**CSIL-6** is a bis-triethoxysilane available as Dynasylan™ BTSE from EVONIK.
**CSIL-7** is a vinyl substituted trimethoxy silane available as Silquest™ VX193 from Momentive Performance Materials Inc.
**CSIL-8** is a silyl terminated polybutyl acrylate available as XMAP SA110S from KANEKA.
**CSIL-9** is a dimethoxysilyl terminated polypropylene oxide available as SILYL SAX015 from KANEKA.
**CSIL-10** is a difunctional dimethoxysiliyl terminated polypropylene oxide available as SILYL SAT010 from KANEKA.
**Kemira™ RDI-S** is a alumina surface treated rutile titanium dioxide pigment available from KEMIRA.
**DB162** is an abbreviation used for the polymeric dispersant Disperbyk™ 162 available from BYK CHEMIE GMBH whereof the solvent mixture of 2-methoxy-1-methylethylacetate, xylene and n-butylacetate was removed.
**INHIB** is a mixture forming a polymerization inhibitor having a composition according to Table 3.

**Table 3**

| **Component** | **wt%** |
|---|---|
| VEEA | 82.4 |
| p-methoxyphenol | 4.0 |
| BHT | 10.0 |
| Cupferron™ AL | 3.6 |

**Cupferron™ AL** is aluminum N-nitrosophenylhydroxylamine from WAKO CHEMICALS LTD.
**TPO** is trimethylbenzoyl diphenyl phosphine oxide supplied as Omnirad™ TPO by IGM.
**BAPO** is a bis(2,4,6-trimethylbenzoyl)-phenylphosphineoxide photoinitiator available as Irgacure™ 819 from BASF.
**Esacure™ KIP IT** is a mixture of 65% KIP150 diluted with 35% glycerol propoxylate triacrylate available from FRATELLI LAMBERTI SPA.
**KIP150** is an oligomeric polyfunctional alpha-hydroxyketone available as Esacure™ KIP 150 from FRATELLI LAMBERTI SPA.
**VEEA** is 2-(vinylethoxy)ethyl acrylate available from NIPPON SHOKUBAI, Japan.
**DTMPTA** is ditrimethylolpropane tetraacrylate available as Sartomer™ SR355 from ARKEMA.
**TMPTA** is trimethylolpropane triacrylate available as Sartomer™ SR351 from ARKEMA.
**Ebecryₗ™ 1360** is polysiloxane hexaacrylate available from CYTEC Industries.
**BNCO** is a 50% solution of a blocked isocyanate in HBA made by evoporating the organic solvent present in Trixene™ BI7982 from BAXENDEN CHEMICALS.
**HBA** is 4-hydroxybutyl acrylate.
**Kapton™500VN** is a 125µm thick polyimide film from DUPONT.
**Apical™ 200NP** is a polyimide substrate from KANEKA.
**Apical™ 200AV** is a thermoset polyimide substrate from KANEKA.
**SF305C 0515** is a polyimide base coverlayer from SHENGYI.
**SF308C 1025** is a polyimide base coverlayer from SHENGYI.

### Measurement Methods

### 1. Average particle size

The particle size of pigment particles in the inkjet ink was determined by photon correlation spectroscopy at a wavelength of 633 nm with a 4mW HeNe laser on a diluted sample of the ink. The particle size analyzer used was a MalvernTM nano-S available from Goffin-Meyvis.

The sample was prepared by addition of one drop of inkjet ink to a cuvette containing 1.5 mL ethyl acetate and mixed until a homogenous sample was obtained. The measured particle size is the average value of 3 consecutive measurements consisting of 6 runs of 20 seconds.

### 2. Viscosity

The viscosity of the formulations was measured at 45°C using a "Robotic Viscometer Type VISCObot" from CAMBRIDGE APPLIED SYSTEMS.

### For inkjet printing, a viscosity of less than 15 mPa.s at 45°C is preferred. 3. Ink Stability

The viscosity of an inkjet ink was measured before and after storage for 7 days at 60°C. A stable inkjet ink should exhibit a difference in viscosity of no more than 15%.

### 3. Surface Tension

The static surface tension of the UV curable inks was measured with a KRÜSS tensiometer K9 from KRÜSS GmbH, Germany at 25°C after 60 seconds.

### 4. Pencil hardness

The scratch resistance was tested using an ElcometerTM 501 Pencil Hardness tester. The measurement is carried out by moving pencils of different hardness, under a known constant pressure over the test surface according to the ASTM test method D 3363 which defines the angle and pressure to perform the test. The evaluation varies from 9B (softest) to 9H (hardest). For manufacturing PCBs a pencil hardness of 7H or more is desired.

| |
|---|
| **9B-8B-7B-6B-5B-4B-3B-2B-B-HB-F-H-2H-3H-4H-5H-6H-7H-8H-9H** |
| softest softer harder hardest |

### 5. Bending test

The Elcometer™ 1500 Cylindrical Mandrel on a Stand is an instrument used for measuring the elasticity, adhesion and cracking of dry ink on flat substrates. It consists of a mandrel support which also serves as a test stand. The substrates are manually and successively bent around metal cylindrical mandrels of decreasing diameter (32, 25, 20, 16, 13, 12, 10, 8, 6, 5, 4, 3, and 2 mm) until cracks appear. The smaller the diameter before any cracks appear, the better the result. For Flex PCBs, a value of no more than 5 mm is desired.

### 6. Adhesion

The adhesion was evaluated by a cross-cut test according to ISO2409:1992(E). Paints. International standard. 1992-08-15. An Elcometer™ 1542 was used as crosshatch cutter having a spacing of 1 mm between cuts and using a weight of 600 g, in combination with a Tesatape™ Black 4104/04 tape.

The evaluation was made in accordance with the evaluation values described in Table 4. Excellent adhesion means that a score of 0 or 1 is obtained, while a score of 2 or 3 is regarded as acceptable. A score of 4 or more is unacceptable.

**Table 4**

| **Score** | **Observation** |
|---|---|
| **0** | The edges of the cuts are completely smooth: none of the squares of the lattice is detached (=perfect adhesion). |
| **1** | Detachment of small flakes of the coating at the intersections of the cuts. A cross-cut area not greater than 5% is affected. |
| **2** | The coating has flaked along the edges and/or at the intersections of the cuts. A cross-cut area greater than 5%, but not significantly greater than 15%, is affected. |
| **3** | The coating has flaked along the edges of the cuts partly or wholly in large ribbons, and/or it has flaked partly or wholly on different parts of the squares. A cross-cut area significantly greater than 15%, but not significantly greater than 35%, is affected. |
| **4** | The coating has flaked along the edges of the cuts in large ribbons, and/or some of the squares has detached partly or wholly.. A cross-cut area significantly greater than 35%, but not significantly greater than 65%, is affected. |
| **5** | Any degree of flaking that cannot even be classified by classification 4. |

### Example 1

This example illustrates the effect of the type of silane compound on the adhesion of the UV free radical curable inkjet ink used in the invention to a polyimide substrate.

### Preparation of Inkjet Inks

A concentrated white pigment dispersion DISP-W was prepared having a composition according to Table 5.

**Table 5**

| **wt% of :** | **DISP-W** |
|---|---|
| **Kemira™ RDI-S** | 50.0 |
| **DB162** | 4.0 |
| **INHIB** | 1.0 |
| **VEEA** | 45.0 |

The concentrated white pigment dispersion DISP-W was made by mixing in VEEA as liquid medium, 1500 g of the white pigment Kemira™ RDI-S, 30 g of the inhibitor INHIB and 400 g of a 30% solution of the polymeric dispersant DB162 in VEEA for 30 minutes in a vessel equipped with a DISPERLUX™ disperser (from DISPERLUX S.A.R.L., Luxembourg). This mixture was subsequently milled in a DYNO™-MILL KD MULTILAB from the company WAB Willy A. Bachofen (Switzerland) using 0.40 mm yttrium-stabilized zirconium oxide-beads. The bead mill was filled for 50% with the grinding beads and operated in recirculation mode for 30 minutes by using a tip speed of 8 m/s. The milling chamber was water-cooled during the operation. The average particles size was 232 nm.

The UV free radical curable white inkjet inks COMP-1 to COMP-10 and INV-1 to INV-6 were prepared using the above prepared concentrated white pigment dispersion Disp-W in combination with the components according to Table 6 using a silane compound according to Table 7. The wt% is based on the total weight of the inkjet ink.

**Table 6**

| **Component** | **wt% of component** |
|---|---|
| **Disp-W** | 26.00 |
| **VEEA** | 30.06 |
| **TMPTA** | 18.50 |
| **DTMPTA** | 13.00 |
| **INHIB** | 0.69 |
| **Ebecryl™ 1360** | 0.30 |
| **BAPO** | 3.00 |
| **TPO** | 2.95 |
| **Esacure™ KIP IT** | 3.00 |
| **Silane compound** | 2.50 |

**Table 7**

| **Inkjet Ink** | **Silane compound** |
|---|---|
| **COMP-1** | CSIL-1 |
| **COMP-2** | CSIL-2 |
| **COMP-3** | CSIL-3 |
| **COMP-4** | CSIL-4 |
| **COMP-5** | CSIL-5 |
| **COMP-6** | CSIL-6 |
| **COMP-7** | CSIL-7 |
| **COMP-8** | CSIL-8 |
| **COMP-9** | CSIL-9 |
| **COMP-10** | CSIL-10 |
| **INV-1** | SIL-1 |
| **INV-2** | SIL-1B |
| **INV-3** | SIL-3 |
| **INV-4** | SIL-4 |
| **INV-5** | SIL-5 |
| **INV-6** | SIL-6 |

### Evaluation and Results

For reasons of simplified testing, a number of the inkjet inks were coated instead of inkjet printed. However, the results for coating and inkjet printing are comparable as can be seen from the results for the inkjet inks INV-1, INV-2 and INV-4.

An inkjet ink was coated by on a bar-coater from Braive using a 10 µm wired bar. The coated sample was cured using a Fusion DRSE-120 conveyer equipped with H-bulb, which transported the samples under the UV-lamp at maximum output on a conveyer belt at a speed of 20 m/min. After the UV curing, a heat treatment was given of 30 minutes at 150°C.

Some of the coated inkjet inks were also tested by giving the Flex PCB substrate before coating a corona treatment with an Allbrandt system having two electrodes (secondary: 15 kHz, 15 kV) at 40 mm/sec transporting speed to increase the surface energy of the polyimide substrates above 42 mN/m.

An inkjet ink was inkjet printed unidirectional at 1 dpd and at a jetting temperature of 45°C using an Anapurna™ MW printer from Agfa Graphics. After the UV curing, a heat treatment was given of 30 minutes at 150°C.

All the coated and inkjet printed samples were then evaluated for adhesion. The results are given by Table 8.

**Table 8**

| **Inkjet Ink** | **Application method** | **Corona** | **Adhesion Flex PCB Substrate** | | |
|---|---|---|---|---|---|
| | | | **Kapton™ 500VN** | **Apical™** 200NP | **Apical™** 200AV |
| **COMP-1** | Coating | Yes | --- | 5 | 5 |
| **COMP-2** | Coating | No | 5 | 4 | --- |
| **COMP-3** | Coating | No | --- | 5 | 4 |
| **COMP-3** | Coating | Yes | --- | 4 | 4 |
| **COMP-4** | Coating | No | 4 | 5 | 5 |
| **COMP-4** | Coating | Yes | 4 | 5 | 3 |
| **COMP-5** | Coating | No | 4 | 5 | 5 |
| **COMP-5** | Coating | Yes | 1 | 5 | 5 |
| **COMP-6** | Coating | No | 5 | 5 | 5 |
| **COMP-6** | Coating | Yes | 3 | 4 | 5 |
| **COMP-7** | Coating | No | 5 | 5 | 5 |
| **COMP-7** | Coating | Yes | 5 | 5 | 3 |
| **COMP-8** | Coating | No | 5 | 5 | 5 |
| **COMP-8** | Coating | Yes | 5 | 5 | 5 |
| **COMP-9** | Coating | No | 5 | 5 | 5 |
| **COMP-9** | Coating | Yes | 5 | 5 | 5 |
| **COMP-10** | Coating | No | 5 | 5 | 5 |
| **COMP-10** | Coating | Yes | 5 | 5 | 5 |
| **INV-1** | Coating | No | 0 | 0 | 0 |
| **INV-1** | Inkjet | No | 0 | 0 | 1 |
| **INV-2** | Coating | No | 3 | 0 | 0 |
| **INV-2** | Coating | Yes | 0 | 0 | 0 |
| **INV-2** | Inkjet | No | 0 | 2 | 1 |
| **INV-3** | Coating | No | 0 | 1 | 2 |
| **INV-3** | Coating | Yes | 0 | 0 | 0 |
| **INV-4** | Coating | Yes | 0 | 1 | 2 |
| **INV-4** | Inkjet | No | 0 | 1 | 3 |
| **INV-5** | Coating | No | --- | 2 | 2 |
| **INV-5** | Coating | Yes | --- | 2 | 0 |
| **INV-6** | Coating | No | 0 | 3 | 3 |

From Table 8, it should be clear that only the inkjet inks used in the present invention using the specific silane compounds exhibited the required adhesion results. It can also be seen that a corona treatment may improve the adhesion further.

### Example 2

This example illustrates the effect of the concentration of the silane compound on the adhesion of the UV free radical curable inkjet ink in accordance with the invention to a polyimide substrate.

### Preparation of Inkjet Inks

The concentrated white pigment dispersion Disp-W was used in preparing the UV free radical curable white inkjet inks COMP-11 to COMP-13 and INV-7 to INV-13 according to Table 9 and Table 10.

**Table 9**

| **wt% of component** | **COMP-11** | **INV-7** | **INV-8** | **INV-9** | **INV-10** |
|---|---|---|---|---|---|
| **Disp-W** | 26.00 | 26.00 | 26.00 | 26.00 | 26.00 |
| **VEEA** | 32.56 | 31.56 | 30.06 | 27.56 | 25.56 |
| **TMPTA** | 18.50 | 18.50 | 18.50 | 18.50 | 18.50 |
| **DTMPTA** | 13.00 | 13.00 | 13.00 | 13.00 | 13.00 |
| **INHIB** | 0.69 | 0.69 | 0.69 | 0.69 | 0.69 |
| **Ebecryl™ 1360** | 0.30 | 0.30 | 0.30 | 0.30 | 0.30 |
| **BAPO** | 3.00 | 3.00 | 3.00 | 3.00 | 3.00 |
| **TPO** | 2.95 | 2.95 | 2.95 | 2.95 | 2.95 |
| **Esacure™ KIP IT** | 3.00 | 3.00 | 3.00 | 3.00 | 3.00 |
| **SIL-1** | 0.00 | 1.00 | 2.50 | 5.00 | 7.00 |

**Table 10**

| **wt% of component** | **INV-11** | **INV-12** | **COMP-12** | **COMP-13** | **INV-13** |
|---|---|---|---|---|---|
| **Disp-W** | 26.00 | 26.00 | 26.00 | 26.00 | 26.00 |
| **VEEA** | 22.56 | 17.56 | 12.56 | 7.56 | 31.56 |
| **TMPTA** | 18.50 | 18.50 | 18.50 | 18.50 | --- |
| **DTMPTA** | 13.00 | 13.00 | 13.00 | 13.00 | 10.00 |
| **INHIB** | 0.69 | 0.69 | 0.69 | 0.69 | 0.69 |
| **Ebecryl™ 1360** | 0.30 | 0.30 | 0.30 | 0.30 | 0.30 |
| **BAPO** | 3.00 | 3.00 | 3.00 | 3.00 | 3.00 |
| **TPO** | 2.95 | 2.95 | 2.95 | 2.95 | 2.95 |
| **Esacure™ KIP IT** | 3.00 | 3.00 | 3.00 | 3.00 | 3.00 |
| **SIL-1** | 10.00 | 15.00 | 20.00 | 25.00 | 2.50 |
| **BNCO** | --- | --- | --- | --- | 5.00 |
| **HBA** | --- | --- | --- | --- | 15.00 |

### Evaluation and Results

The inkjet inks were coated by on a bar-coater from Braive using a 10 µm wired bar. The coated sample was cured using a Fusion DRSE-120 conveyer equipped with H-bulb, which transported the samples under the UV-lamp at maximum output on a conveyer belt at a speed of 20 m/min. After the UV curing, a heat treatment was given of 30 minutes at 150°C.

All the coated samples were then evaluated for adhesion. The results are given by Table 11.

**Table 11**

| **Inkjet Ink** | **Adhesion polyimide substrate** | | | |
|---|---|---|---|---|
| | **Apical™ 200AV** | **Apical™ 200NP** | **SF305C 0515** | **SF308C 1025** |
| **COMP-11** | 4 | 5 | 5 | 5 |
| **INV-7** | 0 | 0 | 3 | 0 |
| **INV-8** | 0 | 0 | 1 | 0 |
| **INV-9** | 0 | 0 | 0 | 0 |
| **INV-10** | 0 | 0 | 0 | 1 |
| **INV-11** | 0 | 1 | 0 | 0 |
| **INV-12** | 0 | 2 | 3 | 1 |
| **COMP-12** | brittle | brittle | brittle | brittle |
| **COMP-13** | brittle | brittle | brittle | brittle |
| **INV-13** | 0 | 0 | 0 | 0 |

From Table 11, it can be seen that for achieving good adhesion the silane compound should be present in an amount between 1 and 15 wt% based on the total weight of the UV free radical curable inkjet ink. For the samples COMP-12 and COMP-13, it was observed that the curing speed was drastically reduced, so that the samples COMP-12 and COMP-13 had to be transported under the UV-lamp at maximum output on a conveyer belt at a speed of 20 m/min respectively two and three times. The sample INV-13 illustrates that the combination of a silane compound and a blocked isocyanate compound further improves the adhesion.

### Example 3

This example illustrates the suitability of UV free radical curable white inkjet inks in accordance with the invention for manufacturing Flex PCBs.

### Evaluation and Results

The UV free radical curable white inkjet inks INV-8 and INV-9 were tested for adhesion, bending, and scratch resistance. The surface tension, viscosity and the ink stability were also determined.

The results are given by Table 12.

**Table 12**

| **Property** | **Substrate** | **Heat treatment (30 min/150°C)** | **INV-8** | **INV-9** |
|---|---|---|---|---|
| Adhesion | Kapton™ 500VN | No | 3 | 3 |
| Adhesion | Apical™ 200NP | No | 5 | 5 |
| Adhesion | Apical™ 200AV | No | 5 | 5 |
| Adhesion | Kapton™ 500VN | Yes | 0 | 0 |
| Adhesion | Apical™ 200NP | Yes | 0 | 0 |
| Adhesion | Apical™ 200AV | Yes | 0 | 0 |
| Bending test | Kapton™ 500VN | Yes | 2 | 2 |
| Bending test | Apical™ 200NP | Yes | 2 | 2 |
| Bending test | Apical™ 200AV | Yes | 2 | 2 |
| Viscosity (mPa.s) | --- | --- | 8.7 | 8.6 |
| Ink stability | --- | --- | 5% | 2% |
| Surface tension (mN.m) | --- | --- | 23.9 | 23.4 |
| Pencil hardness | Kapton™ 500VN | Yes | 9H | 9H |

From Table 12, it can be seen that a heat treatment is necessary to obtain excellent adhesion and that the UV free radical curable white inkjet inks INV-8 and INV-9 fulfil all requirements for manufacturing Flex PCBs.

### Reference signs list

**Table 13**

| | |
|---|---|
| **1** | multilayer Flex PCB |
| **2** | polyimide substrate |
| **3** | conductive pattern |
| **4** | second conductive pattern |
| **5** | protective cover layer |
| **6** | adhesive |
| **7** | protective cover layer |
| **8** | access holes |
| **10** | PCB |
| **11** | component legend markings |
| **12** | conductive pattern |

## Claims

1. A manufacturing method for printed circuit boards (1, 10) including the steps of:
a) inkjet printing a UV free radical curable inkjet ink on a substrate (2), wherein the viscosity of the UV free radical curable inkjet ink is smaller than 90 mPa.s at 25°C and at a shear rate of 1,000 s⁻¹;
b) UV curing the UV free radical curable inkjet ink on the inkjet printed substrate; and
c) applying a thermal treatment on the UV cured inkjet printed substrate;
wherein the UV free radical curable inkjet ink contains at least a colorant, a free radical photoinitiator; a duofunctional monomer or oligomer and a polyfunctional monomer or oligomer; and 1 to 15 wt% of a silane compound according to Formula (I): 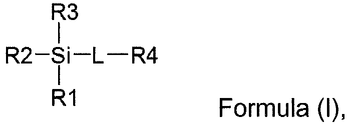 wherein,
the linking group L represents a -CH₂- group or an aliphatic chain having 2 to 10 carbon atoms optionally substituted in the aliphatic chain by a nitrogen or an oxygen;
R1 represents a methoxy group;
R2 and R3 independently represent a methoxy group or a C₁- to C₄-alkyl group; and
R4 represents a functional group selected from the group consisting of an epoxy group, an amine group, a carbamate group, a trimethoxy silane group and an ureido group,
wherein the substrate is a polyimide substrate (2).

2. The manufacturing method according to claim 1, wherein the jetting temperature used in the inkjet printing step a) is not higher than 55°C.

3. The manufacturing method according to claim 1 or 2, wherein the substrate is given a corona treatment before the inkjet printing step a).

4. The manufacturing method according to any one of claims 1 to 3, wherein the thermal treatment generates a temperature of at least 130°C at the surface of the UV cured inkjet printed substrate.

5. The manufacturing method according to any one of claims 1 to 4, wherein the UV curing in step b) is performed using ultraviolet LEDs.

6. A UV free radical curable inkjet ink having a viscosity smaller than 90 mPa.s at 25°C and at a shear rate of 1,000 s⁻¹ containing at least:
a) a colorant;
b) a free radical photoinitiator;
c) a duofunctional monomer or oligomer;
d) a polyfunctional monomer or oligomer;
e) 1 to 15 wt% of a silane compound according to Formula (I): and 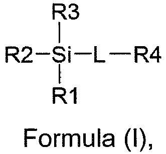 wherein,
the linking group L represents a -CH₂- group or an aliphatic chain having 2 to 10 carbon atoms optionally substituted in the aliphatic chain by a nitrogen or an oxygen;
R1 represents a methoxy group;
R2 and R3 independently represent a methoxy group or a C₁- to C₄-alkyl group; and
R4 represents a functional group selected from the group consisting of an epoxy group, an amine group, a carbamate group, a trimethoxy silane group and an ureido group;
f) a blocked isocyanate compound.

7. The UV free radical curable inkjet ink according to claim 6, including an acyl phosphine oxide type photoinitiator or bisacyl phosphine oxide type photoinitiator.

8. The UV free radical curable inkjet ink according to claim 6 or 7, wherein the colorant is selected from the group consisting of a white pigment, a yellow pigment and a black pigment.

9. The UV free radical curable inkjet ink according to claim 8, wherein the white pigment is a titanium dioxide pigment.

10. The UV curable inkjet ink according to any one of claims 6 to 9, containing 0 to 9 wt% of a monofunctional monomer or oligomer.

11. The UV free radical curable inkjet ink according to any one of claims 6 to 10, wherein the difunctional monomer or oligomer is 2-(2'-vinyloxyethoxy)ethyl acrylate.

12. The UV free radical curable inkjet ink according to any one of claims 6 to 11, further containing a blocked isocyanate compound.

13. A printed circuit board (1, 10) carrying a cured image of UV free radical curable inkjet ink according to any one of claims 6 to 12, wherein the UV free radical curable inkjet ink is provided on a polyimide substrate (2).

14. The printed circuit board according to claim 13, wherein the printed circuit board is a flexible printed circuit board (1).

## Patentansprüche

1. Ein Verfahren zur Herstellung gedruckter Leiterschaltungen (1, 10), das die folgenden Schritte umfasst:
a) Tintenstrahldruck einer durch freie Radikale UV-härtbaren Tintenstrahltinte auf einem Substrat (2), wobei die Viskosität der durch freie Radikale UV-härtbaren Tintenstrahltinte bei weniger als 90 mPa.s bei 25°C und einer Schergeschwindigkeit von 1.000 s⁻¹ liegt,
b) UV-Härtung der durch freie Radikale UV-härtbaren Tintenstrahltinte auf dem durch Tintenstrahldruck bedruckten Substrat, und
c) Anwendung einer Wärmebehandlung auf das durch Tintenstrahldruck bedruckte, UV-gehärtete Substrat,
wobei die durch freie Radikale UV-härtbare Tintenstrahltinte mindestens ein Farbmittel, einen freiradikalischen Fotoinitiator, ein difunktionelles Monomer oder Oligomer und ein polyfunktionelles Monomer oder Oligomer und 1 bis 15 Gew.-% einer Silanverbindung gemäß Formel (I) enthält: 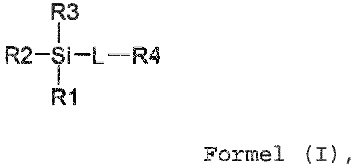 in der
die Bindungsgruppe L eine -CH₂-Gruppe oder eine aliphatische Kette mit 2 bis 10 Kohlenstoffatomen, die gegebenenfalls in der aliphatische Kette durch ein Stickstoffatom oder ein Sauerstoffatom substituiert ist, bedeutet,
R1 eine Methoxygruppe bedeutet,
R2 und R3 unabhängig voneinander eine Methoxygruppe oder eine C₁-C₄-Alkylgruppe bedeuten, und
R4 eine funktionelle Gruppe aus der Gruppe bestehend aus einer Epoxygruppe, einer Aminogruppe, einer Carbamatgruppe, einer Trimethoxysilangruppe und einer Ureidogruppe bedeutet,
wobei das Substrat ein Polyimidsubstrat (2) ist.

2. Das Herstellungsverfahren nach Anspruch 1, wobei die im Tintenstrahldruckschritt a) verwendete Aufspritztemperatur bei nicht mehr als 55°C liegt.

3. Das Herstellungsverfahren nach Anspruch 1 oder 2, wobei das Substrat vor dem Tintenstrahldruckschritt a) einer Koronabehandlung unterzogen wird.

4. Das Herstellungsverfahren nach einem der Ansprüche 1 bis 3, wobei die Wärmebehandlung eine Temperatur von mindestens 130°C an der Oberfläche des UV-gehärteten, durch Tintenstrahldruck bedruckten Substrats generiert.

5. Das Herstellungsverfahren nach einem der Ansprüche 1 bis 4, wobei die UV-Härtung in Schritt b) unter Verwendung von Ultraviolett-LEDs erfolgt.

6. Eine durch freie Radikale UV-härtbare Tintenstrahltinte mit einer Viskosität von weniger als 90 mPa.s bei 25°C und einer Schergeschwindigkeit von 1.000 s⁻¹, die mindestens Folgendes enthält:
a) ein Farbmittel,
b) einen freiradikalischen Fotoinitiator,
c) ein difunktionelles Monomer oder Oligomer,
d) ein polyfunktionelles Monomer oder Oligomer,
e) 1 bis 15 Gew.-% einer Silanverbindung gemäß Formel (I): 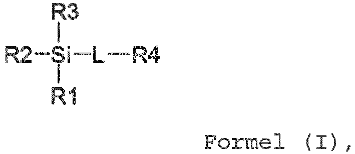 in der
die Bindungsgruppe L eine -CH₂-Gruppe oder eine aliphatische Kette mit 2 bis 10 Kohlenstoffatomen, die gegebenenfalls in der aliphatische Kette durch ein Stickstoffatom oder ein Sauerstoffatom substituiert ist, bedeutet,
R1 eine Methoxygruppe bedeutet,
R2 und R3 unabhängig voneinander eine Methoxygruppe oder eine C₁-C₄-Alkylgruppe bedeuten, und
R4 eine funktionelle Gruppe aus der Gruppe bestehend aus einer Epoxygruppe, einer Aminogruppe, einer Carbamatgruppe, einer Trimethoxysilangruppe und einer Ureidogruppe bedeutet,
f) eine blockierte Isocyanatverbindung.

7. Die durch freie Radikale UV-härtbare Tintenstrahltinte nach Anspruch 6, enthaltend einen Fotoinitiator des Acylphosphinoxid-Typs oder einen Fotoinitiator des Bisacylphosphinoxid-Typs.

8. Die durch freie Radikale UV-härtbare Tintenstrahltinte nach Anspruch 6 oder 7, wobei das Farbmittel aus der Gruppe bestehend aus einem weißen Pigment, einem gelben Pigment und einem schwarzen Pigment ausgewählt wird.

9. Die durch freie Radikale UV-härtbare Tintenstrahltinte nach Anspruch 8, wobei das weiße Pigment ein Titandioxidpigment ist.

10. Die durch freie Radikale UV-härtbare Tintenstrahltinte nach einem der Ansprüche 6 bis 9, die 0 bis 9 Gew.-% eines monofunktionellen Monomers oder Oligomers enthält.

11. Die durch freie Radikale UV-härtbare Tintenstrahltinte nach einem der Ansprüche 6 bis 10, wobei das difunktionelle Monomer oder Oligomer 2-(2'-Vinyloxyethoxy)-ethylacrylat ist.

12. Die durch freie Radikale UV-härtbare Tintenstrahltinte nach einem der Ansprüche 6 bis 11, die ferner eine blockierte Isocyanatverbindung enthält.

13. Eine gedruckte Leiterschaltung (1, 10), die ein gehärtetes Bild einer durch freie Radikale UV-härtbaren Tintenstrahltinte nach einem der Ansprüche 6 bis 12 trägt, wobei die durch freie Radikale UV-härtbare Tintenstrahltinte auf ein Polyimidsubstrat (2) aufgetragen ist.

14. Die gedruckte Leiterschaltung nach Anspruch 13, wobei die gedruckte Leiterschaltung eine biegsame gedruckte Leiterschaltung (1) ist.

## Revendications

1. Procédé de fabrication de cartes à circuits imprimés (1, 10) comprenant les étapes consistant à:
a) imprimer par impression à jet d'encre une encre pour impression à jet d'encre durcissable par rayonnement ultraviolet par radicaux libres sur un substrat (2), la viscosité de l'encre pour impression à jet d'encre durcissable par rayonnement ultraviolet par radicaux libres étant inférieure à 90 mPa.s à 25°C et à une vitesse de cisaillement de 1.000 s⁻¹,
b) durcir par rayonnement ultraviolet l'encre pour impression à jet d'encre durcissable par rayonnement ultraviolet par radicaux libres sur le substrat imprimé par impression à jet d'encre, et
c) appliquer un traitement thermique au substrat imprimé par impression à jet d'encre et durci par rayonnement ultraviolet, **caractérisé en ce que** l'encre pour impression à jet d'encre durcissable par rayonnement ultraviolet par radicaux libres contient au moins une matière colorante, un photoinitiateur de radicaux libres, un monomère ou oligomère difonctionnel et un monomère ou oligomère polyfonctionnel et 1 à 15% en poids d'un composé de silane selon la Formule (I): 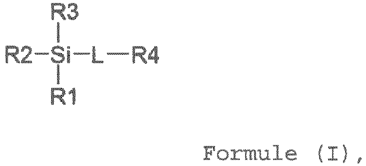 où
le groupe de liaison L représente un groupe -CH₂- ou une chaîne aliphatique à 2 à 10 atomes de carbone étant éventuellement substitué dans la chaîne aliphatique par un atome d'azote ou un atome d'oxygène,
R1 représente un groupe méthoxy,
R2 et R3 représentent, indépendamment l'un de l'autre, un groupe méthoxy ou un groupe alkyle en C₁-C₄, et
R4 représente un groupe fonctionnel choisi parmi le groupe composé d'un groupe époxy, d'un groupe amino, d'un groupe carbamate, d'un groupe triméthoxysilane et d'un groupe uréido, le substrat étant un substrat de polyimide (2).

2. Procédé de fabrication selon la revendication 1, **caractérisé en ce que** la température de projection appliquée lors de l'étape d'impression à jet d'encre a) ne dépasse pas 55°C.

3. Procédé de fabrication selon la revendication 1 ou 2, **caractérisé en ce que** le substrat est soumis à un traitement corona avant l'étape d'impression à jet d'encre a).

4. Procédé de fabrication selon l'une quelconque des revendications 1 à 3, **caractérisé en ce que** le traitement thermique génère une température d'au moins 130°C à la surface du substrat durci par rayonnement ultraviolet et imprimée par impression à jet d'encre.

5. Procédé de fabrication selon l'une quelconque des revendications 1 à 4, **caractérisé en ce que** le durcissement par rayonnement ultraviolet dans l'étape b) s'effectue à l'aide de diodes électroluminescentes à rayonnement ultraviolet.

6. Encre pour impression à jet d'encre durcissable par rayonnement ultraviolet par radicaux libres ayant une viscosité inférieure à 90 mPa.s à 25°C et à une vitesse de cisaillement de 1.000 s⁻¹ contenant au moins:
a) une matière colorante,
b) un photoinitiateur de radicaux libres,
c) un monomère ou oligomère difonctionnel,
d) un monomère ou oligomère polyfonctionnel,
e) 1 à 15% en poids d'un composé de silane selon la Formule (I): 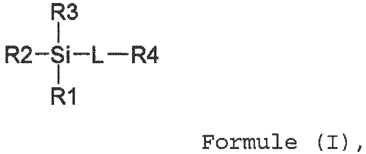 où
le groupe de liaison L représente un groupe -CH₂- ou une chaîne aliphatique à 2 à 10 atomes de carbone étant éventuellement substitué dans la chaîne aliphatique par un atome d'azote ou un atome d'oxygène,
R1 représente un groupe méthoxy,
R2 et R3 représentent, indépendamment l'un de l'autre, un groupe méthoxy ou un groupe alkyle en C₁-C₄, et
R4 représente un groupe fonctionnel choisi parmi le groupe composé d'un groupe époxy, d'un groupe amino, d'un groupe carbamate, d'un groupe triméthoxysilane et d'un groupe uréido,
f) un composé d'isocyanate bloqué.

7. Encre pour impression à jet d'encre durcissable par rayonnement ultraviolet par radicaux libres selon la revendication 6, contenant un photoinitiateur du type d'oxyde d'acylphosphine ou un photoinitiateur du type d'oxyde de bisacylphosphine.

8. Encre pour impression à jet d'encre durcissable par rayonnement ultraviolet par radicaux libres selon la revendication 6 ou 7, **caractérisée en ce que** la matière colorante est choisie parmi le groupe composé d'un pigment blanc, d'un pigment jaune et d'un pigment noir.

9. Encre pour impression à jet d'encre durcissable par rayonnement ultraviolet par radicaux libres selon la revendication 8, **caractérisée en ce que** le pigment blanc est un pigment de dioxyde de titane.

10. Encre pour impression à jet d'encre durcissable par rayonnement ultraviolet par radicaux libres selon l'une quelconque des revendications 6 à 9, contenant 0 à 9% d'un monomère ou oligomère monofonctionnel.

11. Encre pour impression à jet d'encre durcissable par rayonnement ultraviolet par radicaux libres selon l'une quelconque des revendications 6 à 10, **caractérisé en ce que** le monomère ou oligomère difonctionnel est de l'acrylate de 2-(2'-vinyloxyéthoxy)-éthyle.

12. Encre pour impression à jet d'encre durcissable par rayonnement ultraviolet par radicaux libres selon l'une quelconque des revendications 6 à 11, contenant en outre un composé d'isocyanate bloqué.

13. Carte à circuits imprimés (1, 10) portant une image durcie d'une encre pour impression à jet d'encre durcissable par rayonnement ultraviolet par radicaux libres selon l'une quelconque des revendications 6 à 12, **caractérisée en ce que** l'encre pour impression à jet d'encre durcissable par rayonnement ultraviolet par radicaux libres est appliquée sur un substrat de polyimide (2) .

14. Carte à circuits imprimés selon la revendication 13, **caractérisée en ce que** la carte à circuits imprimés est une carte à circuits imprimés (1) flexible.
